# EUROPEAN PATENT APPLICATION

(11) **EP 2 674 832 A2**
(43) Date of publication of application: **18.12.2013**
(21) Application number: 13150657.8
(22) Date of filing: 09.01.2013
(51) Int. Cl.: G06F 1/16

(54) **Portable electronic device**

(30) Priority: 13.06.2012 US 201261659325 P; 09.11.2012 TW 101141873
(71) Applicant: Acer Incorporated, New Taipei City 221 (TW)
(72) Inventor: Lee, Yuan-Hsin, 221 New Taipei City (TW); Chen, Mei-Jung, 221 New Taipei City (TW); Yuan, Chia-Shang, 221 New Taipei City (TW); Chiou, Tzeng-Chih, 221 New Taipei City (TW); Chiang, Wen-Hsien, 221 New Taipei City (TW); Liew, Sze-Thai, 221 New Taipei City (TW); Huang, Ming-Te, 221 New Taipei City (TW); Cheng, Chiao-Ting, 221 New Taipei City (TW)
(74) Representative: Becker Kurig Straus

(57) **Abstract**

A portable electronic device including a first body, a second body, and an assembling structure is provided. The assembling structure includes a first assembling unit and a second assembling unit. The first assembling unit is adapted to hidden in one of the first and the second bodies, and the second assembling unit is disposed and hidden in another one of the first and the second bodies. When the first body is close to the second body, the first assembling unit is protruded out of the first body or the second body, and assembled to the second assembling unit, such that the first and the second bodies are fixed to each other.

## Description

### BACKGROUND OF THE INVENTION

### Field of the Invention

The present invention relates to a portable electronic device and more particularly, to a portable electronic device which the bodies thereof are separable.

### Description of Related Art

To meet the requirement of a light, thin and compact portable electronic device nowadays, the volume of the device is rather limited. For the devices such as mobile phones or tablet PC, if a screen and a keypad are both disposed on the device, the size of the screen has to be reduced. In order to dispose a larger screen in the limited space, a touch screen has been developed recently. By integrating the keypad into the screen as an input interface of the portable electronic device, the cost of and the area occupied by a traditional keypad are saved.

To meet operation demands of different applications, the touch screen displays the corresponding operation interfaces according to the execution demand of each application for a user to operate the functions of the applications by touching. For example, when the user activates a document editing program, a virtual keypad is displayed on the touch screen for the user to input characters. When the user activates a media player program, control keys such as display key, pause key, stop key, forward key, rewind key, etc., are displayed on the touch screen for the user to operate the functions of the media player program.

However, the interfaces such as key pad, control keys, etc., displayed on the touch screen still occupy considerable display space of the screen, other contents are thus compressed which is harder for the user to read. Furthermore, when the user answers the phone by the portable electronic device, the touch screen is turned off to keep the user from touching the touch screen accidentally, so the user can not perform operations on the portable electronic device.

Therefore, there is a need to develop a portable electronic device with greater screen display space and flexible usage to adapt all kinds of operation environments.

### SUMMARY OF THE INVENTION

The present invention provides a portable electronic device which the bodies thereof are separable so as to have more flexible operation status and greater operation range.

A portable electronic device including a first body, a second body and an assembling structure is provided. The assembling structure includes a first assembling unit and a second assembling unit, wherein the first assembling unit is adapted to hidden in one of the first body and the second body. When the first body is close to the second body, the first assembling unit is protruded out of the first body or the second body, and is correspondingly assembled to the second assembling unit, such that the first body and the second body are fixed together.

Based on the above, in the aforesaid embodiments of the present invention, the first body and the second body of the portable electronic device are separable so as to provide the portable electronic device greater and more flexible operation environment. Moreover, the assembling structure includes the first assembling unit and the second assembling unit respectively disposed in the first body and the second body, so that when close to each other, the first body and the second body can be fixed together by the assembling units assembled to each other.

In order to make the aforementioned and other features and advantages of the invention more comprehensible, embodiments accompanying figures are described in detail below.

### BRIEF DESCRIPTION OF THE DRAWINGS

FIG. 1 is a schematic view of a portable electronic device according to an embodiment of the present invention.

FIG. 2 is a schematic view of the portable electronic device in Fig. 1 under another operation status.

FIG. 3 is a usage scenario of the portable electronic device under the status of FIG. 2.

FIG. 4 and FIG. 5 are schematic views respectively illustrating the statuses of the portable electronic device in FIG. 2 after assembled.

FIG. 6 is a schematic view of a portable electronic device according to another embodiment of the present invention.

FIG. 7 is a schematic view of a portable electronic device after assembled according to an embodiment of the present invention.

FIG. 8 is a schematic view of a portable electronic device after assembled according to another embodiment of the present invention.

FIG. 9 is a schematic view of a portable electronic device after assembled according to another embodiment of the present invention.

### DESCRIPTION OF EMBODIMENTS

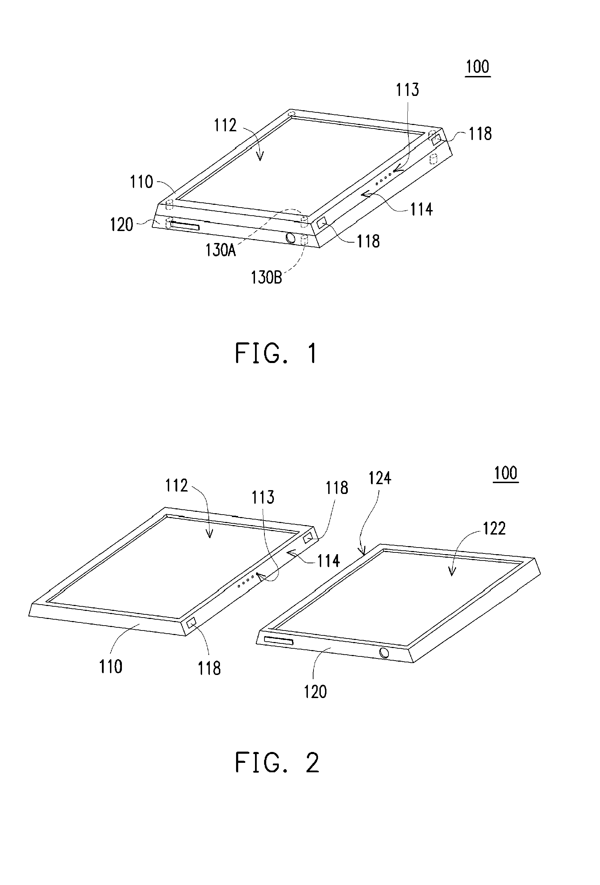

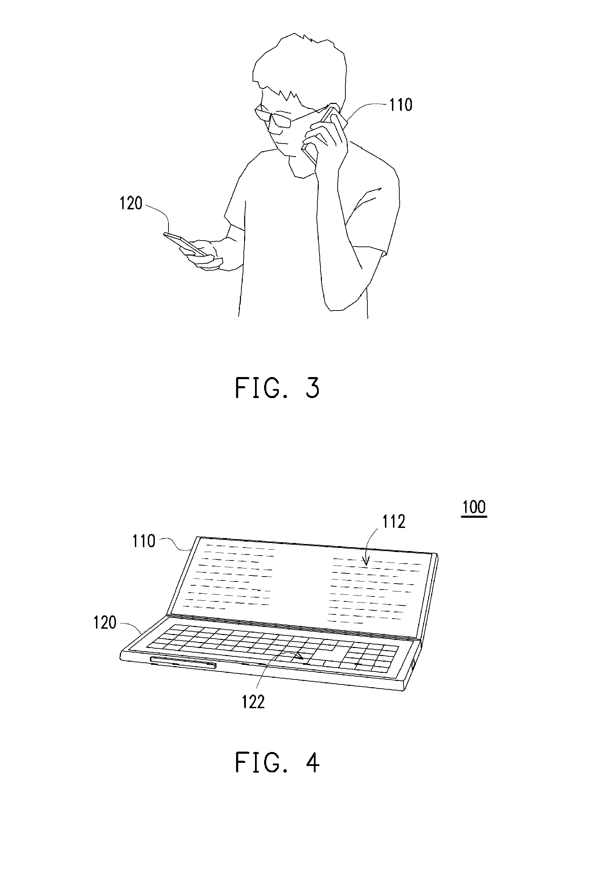

FIG. 1 is a schematic view of a portable electronic device according to an embodiment of the present invention. Fig. 2 is a schematic view of the portable electronic device in Fig. 1 under another operation status. FIG. 3 is a usage scenario of the portable electronic device under the status of FIG. 2. Referring to FIG. 1 to FIG. 3, in the present embodiment, the portable electronic device 100 includes a first body 110 and a second body 120, which achieve the stacked status shown in FIG. 1 by the magnetic assembling elements 130A, 130B respectively disposed therein. When a user applies a force against the magnetic attractive force between the magnetic assembling elements 130A, 130B, the separated status shown in FIG. 2 are achieved. Moreover, in the present embodiment, wireless transmission modules (not shown) can further be respectively disposed on the first body 110 and the second body 120 of the portable electronic device 100 so that the first body 110 and the second body 120 can still be able to proceed data transmission when the first body 110 and the second body 120 are separated from each other.

The first body 110 and the second body 120 respectively have a first display surface 112 and a second display surface 122, which respectively are touch screens. Then, the images displayed on the first display surface 112 and the second display surface 122 are varied according to a connecting condition between the first body 110 and the second body 120 and types of applications being executed.

For example, when the first body 110 and the second body 120 of the portable electronic device 100 are stacked together, the portable electronic device 100 is operated as a mobile phone for a user to dial and answer phone calls or sending and receiving messages. Moreover, when the user uses the portable electronic device 100 to answer a phone call, if the user needs to search some data such as phone numbers of other contacts or the location of the user himself, etc., the second body 120 can be removed from the first body 110, as shown in FIG. 3, such that the user can answer the phone call by the first body 110 and search the needed data by operating the second body 120 at the same time. The search result can be transmitted back to the first body 110 from the second body 120 through the wireless connection between the first body 110 and the second body 120, so as to be transmitted to a user at the other side of the phone through the communicating connection of the first body 110.

Similarly, the second body 120 of the present embodiment further has a photography module (not shown) at the back of the second display surface 122. When a user uses the portable electronic device 100 to answer a phone call, if the user wants to take photos and share the photos, the second body 120 can be removed from the first body 110, such that the user can answer the phone call by the first body 110 and take photos by operating the second body 120 at the same time, and images taken by the second body 120 can be transmitted back to the first body 110 through the wireless connection between the first body 110 and the second body 120, so the images can be transmitted to a user at the other side of the phone through communicating connection of the first body 110.

The above-mentioned usage scenarios are given as examples, and are not intended to limit the scope of the present invention. Users may flexibly use the first body 110 and the second body 120 to execute the needed functions according to actual demands. The present invention is not limited herein.

Furthermore, the present invention does not limit the types of the portable electronic device 100. The above-mentioned first body 110 and the second body 120 can be a thin electronic device such as mobile phone, personal digital assistant (PDA) or tablet PC, etc. In addition, the first body 110 and the second body 120 can be operated independently and also can be stacked and operated as a single device.

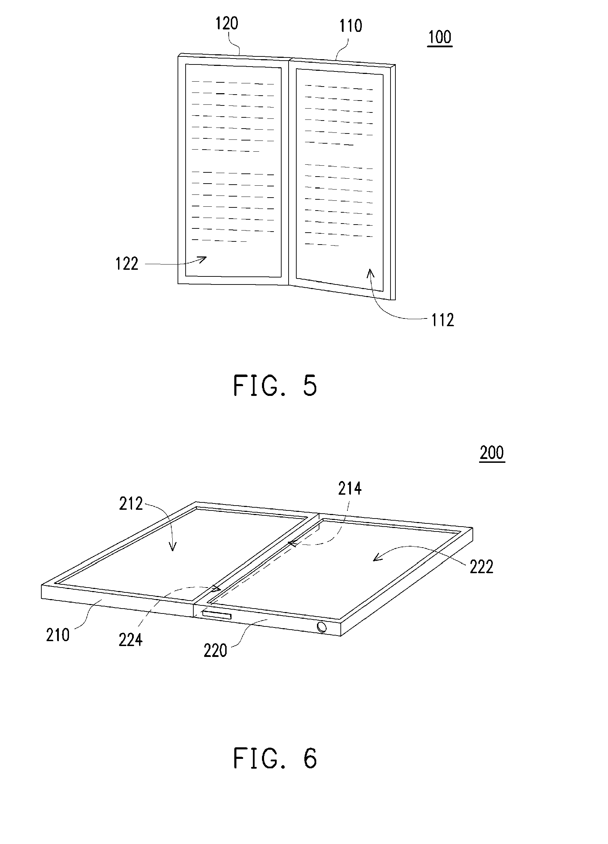

FIG. 4 and FIG. 5 are schematic views respectively illustrating the statuses of the portable electronic device in FIG. 2 after assembled. Referring to FIG. 2, FIG. 4 and FIG. 5, in the present embodiment, the first body 110 has a first side surface 114 adjoining the first display surface 112, and the second body 120 has a second side surface 124 adjoining the second display surface 122, wherein the first display surface 112 and the first side surface 114 include an obtuse angle, and the second display surface 122 and the second side surface 124 include an obtuse angle, such that the first body 110 and the second body 120 respectively have, for the view angle of the front view shown in FIG. 2, features of trapezium contours. Thus, when the first side surface 114 and the second side surface 124 are assembled to each other, the first display surface 112 and the second display surface 122 include an obtuse angle, which shows statuses of tilting relative to each other and not located at the same geometric plane as shown in FIG. 4 and FIG. 5.

For example, referring to FIG. 4, by using the effect of the first display surface 112 raised relative to the second display surface 122, the portable electronic device 100 can now activate the display/operation mode as note books, and the corresponding key patterns generated by the user operating the second display surface 122 can operate the messages displayed on the first display surface 112.

Similarly, referring to FIG. 5, because the first display surface 112 and the second display surface 122 include a included angle which is not 180 degree, the first body 110 and the second body 120 are assembled by the side surfaces thereof and generate the effect as opening a book after being erected, so as to meet the view angles and reading habits of users.

Of course, as shown in FIG. 2, the contour of the first body 110 has four first side surfaces 114, same as the second body 120, surrounding the first display surface 112, so the above-mentioned embodiment only describes the operation status and effect after one of the first side surface 114 is assembled to one of the second side surface 124. Designers may assemble the first body 110 and the second body 120 to each other with any surfaces thereof according to the operation environment and requirements, so as to generate the required operation status and effect. The present invention is not limited herein.

FIG. 6 is a schematic view of a portable electronic device according to another embodiment of the present invention. Referring to FIG. 6, the difference between the present embodiment and the above-mentioned embodiment is that, in the present embodiment, the first display surface 212 of the first body 210 is perpendicular to the first side surface 214, and the second display surface 222 of the second body 220 is perpendicular to the second display surface 224. Accordingly, after the first body 210 and the second body 220 are assembled to each other respectively by the first side surface 214 and the second side surface 224 thereof, a tablet structure as shown in FIG. 6 is formed. At the time, the first display surface 212 and the second display surface 222 are located at the same geometric plane, so the portable electronic device 200 can have greater display area for users to watch.

Based on the above, designers may assemble or arrange the first body and the second body with different connecting relationships by the contours of the bodies.

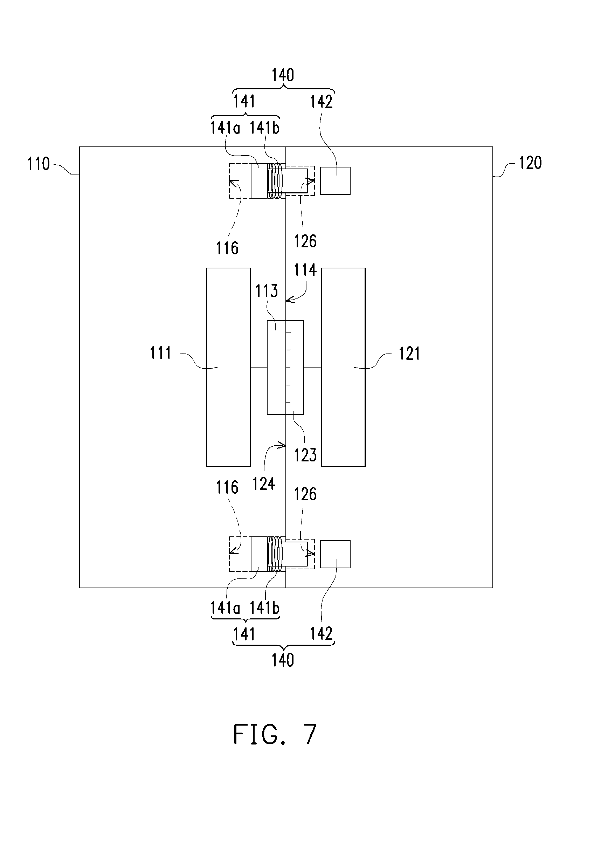

FIG. 7 is a schematic view of a portable electronic device after assembled according to an embodiment of the present invention. Referring to FIG. 2 and FIG. 7, in the present embodiment, the portable electronic device 100 further includes an assembling structure 140, which is disposed in the first body 110 by the first assembling unit 141, and is disposed in the second body 120 by the second assembling unit 142. Therefore, when the first side surface 114 and the second side surface 124 are close to each other, the first assembling unit 141 and the second assembling unit 142 can be assembled to each other.

In addition, the first body 110 further has a first concave 116, and the first assembling unit 141 includes an assembling element 141 a and a restoring element 141b. The assembling element 141a, for example, is a tenon, which is movably disposed in the first concave 116. The restoring element 141b, for example, is a spring, which is sleeved on the tenon and leaned between the assembling element 141a and the first body 110. On the other hand, the second body 120 further has a second concave 126. The second assembling unit 142, for example, is a magnetic component or a magnetic conducting component, which is disposed in the second concave 126, and the assembling element 141 a is also a magnetic component or a magnetic conducting component, so when the assembling element 141a and the second assembling unit 142 are close to each other, a magnetic attractive force is generated therebetween.

Accordingly, when the first body 110 is close to the second side surface 124 of the second body with the first side surface 114, the assembling element 141a and the second assembling unit 142 having magnetic attraction therebetween make the assembling element 141 protruded out of the first concave 116 so as to be lodged in the second concave 126. In other words, when the first body 110 and the second body 120 are separated, the assembling element 141 a is hidden in the first side surface 114 of the first body 110, and the first body 110 shields the first concave 116 by the dust cover 118 such that the integration of the appearance can be maintained. Similarly, the second body 120 can also shield the second concave 126 by a similar structure to achieve the above-mentioned effect. Until the status shown in FIG. 7, the assembling element 141 a is lodged in the second concave 126 due to the magnetic attractive force of the second assembling unit 142, and the restoring element 141b is deformed at the time, such that the first body 110 and the second body 120 are fixed together by the assembling structure 140 for the user to use under the statuses shown in FIG. 4, FIG. 5 or FIG. 6. The portable electronic device 100 thus can have enough structure strength.

On the contrary, when the first body 110 and the second body 120 are separated again, the restoring element 141b drives the assembling element 141a moving back in the first concave 116. It is noted that, the magnetic attractive force between the second assembling unit 142 and the assembling element 141 a is greater than the elastic force applied on the assembling element 141a by the restoring element 141b to ensure that the first assembling unit 141 can achieve the status shown in FIG. 7.

The number and the method of the first assembling unit 141 and the second assembling unit 142 respectively disposed on the first body 110 and the second body 120 are not limited herein. As shown in FIG. 7, the first assembling unit 141 and the second assembling unit 142 of the present embodiment are respectively disposed in pair on the bodies close to one of the side surfaces and correspond to each other. However, designers may dispose the same assembling structures on the bodies correspondingly according to the assembling requirement between the bodies.

In addition, the first body 110 further has a first electronic module 111 and a first connector 113 electrically connected to each other, and the first connector 113 is exposed by the first side surface 114. The second body 120 further has a second electronic module 121 and a second connector 123, and the second connector 123 is exposed by the second side surface 124. In the present embodiment, the first electronic module 111 and the second electronic module 121, for example, are battery modules. When the first side surface 114 contacts the second side surface 124, the first connector 113 is connected to the second connector 123, such that the first electronic module 111 is electrically connected to the second electronic module 121. In other words, the first body 110 and the second body 120 can be backup power source for each other so as to supply power for emergency purposes when one of the bodies is in low-power status.

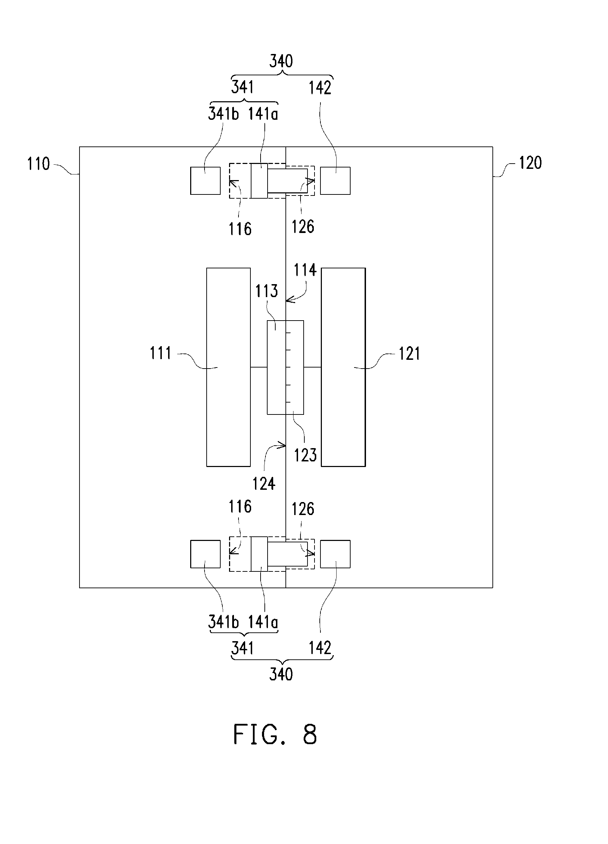

FIG. 8 is a schematic view of a portable electronic device after assembled according to another embodiment of the present invention. Referring to FIG. 8, the difference between the present embodiment and the above-mentioned embodiment is that, in the assembling structure 340 of the portable electronic device 300, the restoring element 341b of the first assembling unit 341 is a magnetic component or magnetic conducting component disposed in the first concave 116, and the restoring element 341b and the assembling element 141a have a magnetic attractive force therebetween.

In other words, the assembling element 141a of the present embodiment achieves the restoring effect by the magnetic attractive force of the restoring element 341b toward the assembling element 141a. That is to say, when the first side surface 114 is close to the second side surface 124, the assembling element 141a is located between the restoring element 314b and the second assembling unit 142, and the magnetic attractive force between the second assembling unit 142 and the assembling element 141 a is greater than the magnetic attractive force between the restoring element 341b and the assembling element 141a, so as to ensure that the first assembling unit 341 achieves the status shown in FIG. 8. Once the first body 110 and the second body 120 are separated, which means the magnetic attractive force between the second assembling unit 142 and the assembling element 141 a is vanished, the assembling element 141a moves back to the first concave 116 and is hidden in the first side surface 114 due to the magnetic attractive force of the restoring element 341 toward the assembling element 141a.

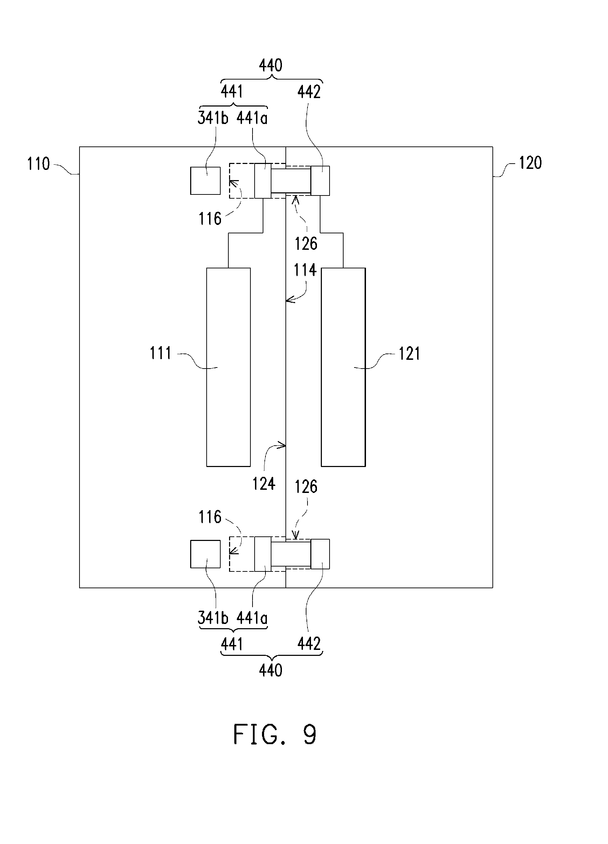

FIG. 9 is a schematic view of a portable electronic device after assembled according to another embodiment of the present invention. Referring to FIG. 9, the difference between the present embodiment and the above-mentioned embodiment is that the assembling element 441a of the first assembling unit 441 and the second assembling unit 442 are connector structures coupled to each other. That is to say, the first electronic module 111 and the second electronic module 121 are respectively disposed in the first body 110 and the second body 120. The first electronic module 111 is electrically connected to the assembling element 441a, and the second electronic module 121 is electrically connected to the second assembling unit 442. Accordingly, when the assembling element 441 a is protruded out of the first concave 116 and is lodged in the second concave so as to be connected to the second assembling unit 442, the first electronic module 111 and the second electronic module 121 are electrically connected to each other by the assembling structure 440.

In sum, in the aforesaid embodiments of the present invention, the first body and the second body of the portable electronic device are separable and also can be reassembled, so as to provide the portable electronic device greater and more flexible operation status. Moreover, the assembling structure includes the first assembling unit and the second assembling unit respectively disposed in the first body and the second body, so that when close to each other, the first body and the second body can be fixed together by the assembling units assembled to each other.

## Claims

1. A portable electronic device (100), comprising:
a first body (110);
a second body (120);
an assembling structure (140), comprising:
a first assembling unit (141), adapted to hidden in one of the first body (110) and the second body (120); and
a second assembling unit (142), disposed and hidden in another one of the first body (110) and the second body (120), wherein when the first body (110) is close to the second body (120), the first assembling unit (141) is protruded out of the first body (110) or the second body (120), and assembled to the second assembling unit (142), such that the first body (110) and the second body (120) are fixed to each other.

2. The portable electronic device (100) as claimed in claim 1, wherein the first body (110) has a first display surface (112) and a first side surface (114) adjoining the first display surface (112), the second body (120) has a second display surface (122) and a second side surface (124) adjoining the second display surface (122), the first assembling unit (141) is adapted to protruded out or hidden in the first side surface (114) of the first body (110), the second assembling unit (142) is hidden in the second side surface (124) of the second body (120), when the first body (110) and the second body (120) are fixed together, the first side surface (114) is overlapped with the second side surface (124).

3. The portable electronic device (100) as claimed in claim 2, wherein when the first side surface (114) is overlapped with the second side surface (124), the first display surface (112) and the second display surface (122) include an obtuse angle.

4. The portable electronic device (100) as claimed in claim 2, wherein the first assembling unit (141) comprises:
an assembling element (141a), movably disposed in the first body (110); and
a restoring element (141b), disposed in the first body (110), the restoring element (141b) driving the assembling element (141a) to be hidden in the first side surface (114) of the first body (110).

5. The portable electronic device (100) as claimed in claim 4, wherein the second assembling unit (142) and the assembling element (141a) have magnetic attraction therebetween.

6. The portable electronic device (100) as claimed in claim 5, wherein the restoring element (141b) is a spring, leaning between the assembling element (141a) and the first body (110), when the first side surface (114) is close to the second side surface (124), magnetic attractive force between the second assembling unit (142) and the assembling element (141a) is greater than elastic force applied on the assembling element (141a) by the spring.

7. The portable electronic device (100) as claimed in claim 5, wherein the assembling element (141a) and the restoring element (141b) have magnetic attraction therebetween, when the first side surface (114) is close to the second side surface (124), the assembling element (141a) is located between the restoring element (141b) and the second assembling unit (142), and magnetic attractive force between the second assembling unit (142) and the assembling element (141a) is greater than magnetic attractive force between the restoring element (141b) and the assembling element (142).

8. The portable electronic device (100) as claimed in claim 1, wherein the first assembling unit (141) and the second assembling unit (142) are connector structures coupled to each other.

9. The portable electronic device (100) as claimed in claim 8, further comprising a first electronic module (111) and a second electronic module (121), respectively disposed in the first body (110) and the second body (120), wherein the first electronic module (111) is electrically connected to the first assembling unit (141), the second electronic module (121) is electrically connected to the second assembling unit (142), when the first assembling unit (141) is assembled to the second assembling unit (142), the first electronic module (111) and the second electronic module (121) are electrically connected to each other by the assembling structure (140).

10. The portable electronic device (100) as claimed in claim 1, wherein the first body (110) further has a first electronic module (111) and a first connector (113) electrically connected to each other, and the first connector (113) is exposed by the first side surface (114), and the second body (120)further has a second electronic module (121) and a second connector (123) electrically connected to each other, and the second connector (123) is exposed by the second side surface (124), when the first side surface (114) contacts the second side surface (124), the first connector (113) is connected to the second connector (123), such that the first electronic module (111) is electrically connected to the second electronic module (121).
